# EUROPEAN PATENT SPECIFICATION

(11) **EP 2 572 188 B1**
(45) Date of publication and mention of the grant of the patent: **05.03.2014**
(21) Application number: 10731827.1
(22) Date of filing: 21.05.2010
(51) Int. Cl.: G01N 24/08, G01R 33/46, G01R 33/465, G01R 33/48, G01N 30/72, H01J 49/00

(54) **ANALYTICAL APPARATUS COMPRISING AN ELECTROCHEMICAL FLOW CELL AND A STRUCTURE ELUCIDATION SPECTROMETER**
ANALYSATOR MIT EINER ELEKTROCHEMISCHEN DURCHFLUSSZELLE UND EINEM STRUKTURAUFKLÄRUNGSSPEKTROMETER
APPAREIL D'ANALYSE COMPRENANT UNE CELLULE D'ÉCOULEMENT ÉLECTROCHIMIQUE ET UN SPECTROMÈTRE D'ÉLUCIDATION DE STRUCTURE

(43) Date of publication of application: 27.03.2013
(73) Proprietor: Antec Leyden B.V., 2382 NV Zoeterwoude (NL)
(72) Inventor: BROUWER, Hendrik-Jan, NL-2353 WL Leiderdorp (NL); KRAJ, Agnieszka, NL-2341 PL Oegstgeest (NL); CHERVET, Jean-Pierre, NL-1017 CC Amsterdam (NL)
(74) Representative: Nederlandsch Octrooibureau
(86) International application number: PCT/NL2010/050309
(87) International publication number: WO 2011/145923

(56) References cited:
- WO-A2-03/081208
- US-B2- 7 028 537
- CAO G X ET AL: "Nafion-Coated Bismuth Film and Nafion-Coated Mercury Film Electrodes for Anodic Stripping Voltammetry Combined On-Line with ICP-Mass Spectrometry", JOURNAL OF THE AMERICAN SOCIETY FOR MASS SPECTROMETRY, ELSEVIER SCIENCE INC, US, vol. 17, no. 7, 1 July 2006 (2006-07-01), pages 945-952, XP025114180, ISSN: 1044-0305, DOI: DOI:10.1016/J.JASMS.2006.03.001 [retrieved on 2006-07-01]
- Lohmann W. et al: "Electrochemistry and LC-MS for Metabolite Generation and Identification: Tools, Technologies and Trends", online LCGC EUROPE, vol. 23, no. 1 1 January 2010 (2010-01-01), pages 1-5, XP002621528, Retrieved from the Internet: URL:http://chromatographyonline.findanalyt ichem.com/lcgc/Misc/Electrochemistry-and-L CndashMS-for-Metabolite-Gene/ArticleStanda rd/Article/detail/652119 [retrieved on 2011-02-09]
- BACA A J ET AL: "Anodic stripping voltammetry combined on-line with inductively coupled plasma-MS via a direct-injection high-efficiency nebulizer", ANALYTICAL CHEMISTRY 20030515 AMERICAN CHEMICAL SOCIETY US, vol. 75, no. 10, 15 May 2003 (2003-05-15), pages 2507-2511, XP002621351, DOI: DOI:10.1021/AC026257S
- Kraj, A. et al: "Automated Screening of Numerous Samples on Phase I and II Metabolism using EC/LC/MS", Online , 2010, XP002621352, Internet Retrieved from the Internet: URL:http://www.myantec.com/downloads/prese nted/abs/Poster2%20-%20AutomatedAB_Sciex.p df [retrieved on 2011-02-09]

## Description

### TECHNICAL FIELD OF THE INVENTION

The present invention relates to an analytical apparatus for sequentially analyzing a plurality of samples containing electrochemically active substances, said apparatus comprising an electrochemical flow cell and a structure elucidation spectrometer selected from a mass spectrometer and a Nuclear Magnetic Resonance (NMR) spectrometer.

The invention further provides an automated method of sequentially analyzing a plurality of samples, said method comprising: (i) passing a flow of fluid sample containing electrochemically active substances through an electrochemical flow cell to produce a flow of electrochemically treated (oxidized or reduced) sample; and (ii) analyzing at least a part of the so treated sample in a structure elucidation spectrometer.

### BACKGROUND OF THE INVENTION

The coupling of Electrochemistry (EC) with Mass Spectrometry (MS) has shown great potential for the investigation of a large variety of redox-active compounds. The use of EC/MS has extended towards applications such as: fast synthesis of metabolites, rapid risk assessments of drug-protein binding, signal enhancement in MS, oxidative damage of DNA, cleavage of proteins etc. Below, a short summary is given of the most important application fields:
- Fast synthesis of oxidative metabolites: Oxidation reactions, occurring in drug metabolism, are regulated by enzymes (e.g. cytochrome P450). Traditional research involves time-consuming *in-vitro* or *in-vivo* methods. Therefore, mimicking of oxidative metabolic processes using electrochemistry is of great interest as a fast screening tool. Bruins and co-workers have systematically investigated oxidation reactions that can be induced with EC (Rapid Commun Mass Spectrom 2000, 14, 529-33 and Rapid Commun Mass Spectrum 2003, 17, 800-810). They concluded that especially 1e⁻ oxidation reactions, such as N-dealkylation, S-oxidation, P-oxidation, alcohol oxidation and dehydrogenation, can successfully be mimicked to study the oxidative metabolism of pesticides and drugs, including caffeic acid, diclofenac, troglitazone, tetrazepam, and toremifen.
- Rapid risk assessments of drug-protein binding: Investigation of drug-protein adducts by conventionally used techniques (e.g. *in-vivo* studies) are very laborious and often inefficient. With the application of EC, it is possible to activate proteins and drugs within seconds to undergo covalent drug-protein binding.
   (Karst and co-workers, Anal. Chem., 2008, 80, 9714-9719).
- Signal enhancement in MS Proteomics: EC/LC/MS can enhance the signal intensity in MS by using, for instance, electroactive derivatizing agent (e.g. N-(2-Ferroceneethyl) maleimide (FEM) for stabilizing thiol groups in proteins) or by directly improving ionization efficiency. (Van Berkel, Anal Chem, 1995, 67, 3643-49).
- Oxidative cleavage of proteins: EC can be used as a tool for protein digestion. Bruins and co-workers (Rapid Commun Mass Spectrom 2003, 17, 1585-92 and J Am Soc Mass Spectrom 2004, 15, 1707-16) have introduced EC as an alternative protein digestion method and were able to cleave proteins, including insulin, α-lactalbumin and carbonic anhydrase, at tyrosine and tryptophan residues.
- Oxidative damage of DNA: On-line EC/ESI-MS is a novel tool for studying oxidative processes of nucleic acids, as well as for studying the formation of covalent drug adducts with nucleic acids. (F. Pitterl, J.P. Chervet, H. Oberacher, Anal Bioanal Chem, 397(3), 2010, 1203-1215 and patent application PCT/NL2010/050014))

All these applications illustrate the tremendous power and broad applicability of electrochemistry as a promising tool to mimic nature's Redox reactions, including drug/xenobiotoc metabolism, oxidative damage of DNA, protein stress, lipid oxidation, etc.

There is an increasing need for a powerful screening tool to process/screen multiple samples on their oxidative or reductive (Redox) behavior. The existing EC/MS and EC/LC/MS hardware approaches described above belong to one of the following categories: 1.'online': EC cell integrated in the LC flow path (pre or post-column) 2 'offline': EC cell connected to an injection valve, whereby the sample is delivered to the EC cell via a manually filled (syringe) pump, which is connected to a MS or LC/MS system.

In the paragraphs below the advantages and disadvantages of the existing approaches are explained:
1. 'Online' generation of oxidized/reduced species and analysis using EC/LC/MS or LC/EC/MS:
   Apparatus for online analysis of samples containing electrochemically active substances comprising an electrochemical flow cell and a structure elucidation spectrometer are known in the art.

   US 7,028,537 describes a system for measuring sample solutions containing electroactive materials, said system comprising a high performance liquid chromatography system outputting an eluent; a coulometric electrochemical flow cell receiving the eluent and electrochemically converting materials in said eluent to charged materials; and a mass spectrometry system receiving eluent outputted from the electrochemical flow cell.
   The EC/LC/MS approach described in US 7,028,537 relies on the online generation of electrochemically oxidized or reduced species after injection using an electrochemical cell integrated in the LC flow path (pre- or post column). Although with such apparatus automated sequential analysis of a plurality of electroactive samples is possible, it has the drawback that the oxidation/reduction conditions in the electrochemical cell are governed by the LC separation conditions used within the method. This limits the control over important parameters determining the oxidation/reduction efficiency such as flow rate, mobile phase composition and pH. Such parameters are important to establish optimized conditions for electrochemical conversion.
   Moreover, the coulometric electrochemical flow cells described in US 7,028,537 are sensitive to fouling due to adsorption of contaminants in the mobile phase or sample/reaction products onto the electrode surface. In case coulometric flow cells are used typically organic modifier contents of 50% or more are required to minimize fouling. Such high solvent concentrations are undesirable as they may adversely affect the separation performance of e.g. HPLC. Another shortcoming of this configuration is the need for high pressure electrochemical cells. With the increasing use of e.g., Ultra High Pressure Liquid Chromatography (e.g. UHPLC or UPLC) such cells must withstand pressures of more than 1500 bar. Such cells are yet not available.
   Follow-up reactions of the oxidized or reduced species in this configuration can only be performed by adding and mixing reactants (for example glutathione) before/after the electrochemical flow cell using an infusion pump in combination with a mixing coil/tee. Thus, this configuration is not suitable for automated screening of follow-up reactions in oxidized or reduced samples with a large variety of different reactants.
2. 'Offline' generation of oxidized/reduced species and analysis using EC/MS or EC/LC/MS: Another existing approach by Uwe Karst and coworkers is based on the 'offline' conversion of electrochemically active samples using an electrochemical flow cell connected to a sampling valve (Anal Bioanal Chem, 2008, 391,79-96). In this configuration a (syringe) pump is used to deliver sample into the electrochemical flow cell and to fill a sample loop of an injection valve with oxidized/reduced sample. Such configuration has the advantage that the electrochemical conversion conditions are completely independent from the HPLC conditions in the LC flow path. In this particular case one has full control over the parameters determining the oxidation/reduction efficiency such as, for example, conversion flow rate, mobile phase composition, modifier concentration and pH and one is able to optimize the conversion conditions. The electrochemical conversion in this configuration takes place at low or atmospheric pressure, allowing the use of any type of electrochemical flow cell, even thin-layer flow cells which need to be operated at low or moderate pressure conditions. Furthermore, in this configuration the electrochemical conversion is fully decoupled from the Electrospray Ionization process (ESI) at the MS, eliminating possible grounding issues or interference from the ESI voltage on the electrochemical cell.

However, this static configuration does not allow automated sequential analysis of a plurality of samples without user intervention.

The aforementioned techniques each have their specific pros and cons. Hence, there is a need for an apparatus/configuration that combines the advantages of both techniques and that allows fast automated electrochemical conversion and analysis of large numbers of electro-active samples using EC/MS or EC/LC/MS, or even EC/NMR or EC/LC/NMR. Such apparatus would provide a powerful diagnostic tool for the automated screening of large amounts of redox-active samples (drugs, xenobiotics, DNA, proteins etc.) The article Cao G.X. et al., Journal of the American Society for Mass Spectrometry, vol. 17, no. 7, 1 July 2006, pages 945-952 discloses an apparatus suitable for analyzing a plurality of samples, the apparatus comprising a sample conduit, an electrochemical flow cell, a source of carrier fluid, a structure elucidation spectrometer, an in-line sample reservoir and a conduit.

### SUMMARY OF THE INVENTION

The inventors have developed a novel and flexible approach for automatic screening/analysis of a plurality of electro-active samples, using an apparatus that comprises a combination of an electrochemical flow cell and a structure elucidation spectrometer (MS or NMR) and that can be operated in two alternating operating modes.

The inventors have found that the drawbacks the drawbacks of the prior art techniques are largely overcome by an apparatus in which the electrochemical flow cell is integrated in the sample aspiration path of an automatic sampling device and where the operation of the electrochemical flow cell is completely decoupled from the operation of the structure elucidation spectrometer. Thus, the invention provides an apparatus for sequentially analyzing a plurality of samples containing electrochemically active substances, said apparatus comprising: a sample conduit; an electrochemical flow cell; a source of carrier fluid; a structure elucidation spectrometer (MS or NMR); a conduit and an in-line sample reservoir (e.g. a sample loop), wherein the apparatus is arranged to operate in:
a) a first operating modus wherein the sample conduit is connected to the conduit via the electrochemical flow cell and the in-line sample reservoir, and the source of carrier fluid is connected to the by-passing the in-line sample reservoir, and
b) a second operating modus wherein the sample conduit is connected to the conduit by-passing the in-line sample reservoir, and the source of carrier fluid is connected to the structure elucidation spectrometer via the in-line sample reservoir.

The invention offers the advantage that a plurality of samples can be analyzed sequentially and fully automatically. In addition, the decoupling of the electrochemical cell from the structure elucidation spectrometer and (optional) analytical separation system, e.g. HPLC, allows for uncompromised selection of optimal electrochemical as well as separation conditions.

The invention also provides an automated method of sequentially analyzing a plurality of samples containing potentially electrochemically active substances, said method comprising the steps of:
a) providing a first fluid sample into a sample conduit;
b) operating an apparatus for sequentially analyzing a plurality of samples in a first operating modus wherein a first flow is generated from the sample conduit to a conduit via an electrochemical flow cell in which a potential is applied to produce a flow of electrochemically treated sample and an in-line sample reservoir to fill the in-line sample reservoir with the electrochemically treated sample, and a second flow is generated from a source of carrier fluid to a structure elucidation spectrometer, said second flow by-passing the in-line sample reservoir;
c) switching the apparatus to a second operating modus once the in-line sample reservoir has been filled with treated sample, wherein the first flow is maintained from the sample conduit to the conduit, said first flow by-passing the in-line sample reservoir, and the second flow is maintained from the source of carrier fluid to the structure elucidation spectrometer via the in-line sample reservoir to transfer at least a part of said treated sample from the in-line sample reservoir to the structure elucidation spectrometer;
d) analyzing the at least part of the treated sample in the structure elucidation spectrometer;
e) providing another sample into the sample conduit; and
f) repeating steps b) to e) for at least 5 more times.

The present apparatus and method can provide the following specific advantages:
- parameters influencing the electrochemical conversion efficiency such as flow rate, pH, composition of the sample fluid passing through the electrochemical cell, can be controlled independently of the flow rate, pH and composition of the carrier fluid in the EC/MS or EC/LC/MS;
- high and ultra high pressures can be employed to transfer carrier fluid, via e.g. an HPLC or UPLC, to a mass spectrometer whilst at the same time employing low or atmospheric pressure in the electrochemical flow cell. This decreases the change of leakage of the electrochemical flow cell and allows the use of a wide variety of electrochemical flow cell geometries;
- the electrochemical flow cell can be cleaned between each sample introduction without introducing washing solvents or any contaminants into the structure elucidation spectrometer and minimizing sample carry over between each sample introduction;
- elimination of possible grounding issues or interference from the MS (ESI voltage) on the electrochemical cell and *vice versa;*
- a plurality of different samples can be electrochemically converted and analyzed sequentially without user intervention;
- the use of the aspirate, dispense, mix etc. functionality of an automatic sampling device allows the automated addition of a plurality of reactants pre- or post electrochemical reaction of the sample fluid prior to analysis, without the use of external fluid delivery systems or user intervention;

### BRIEF DESCRIPTION OF THE DRAWINGS

Embodiments of the invention will now be described, by way of example only, with reference to the accompanying schematic drawings in which corresponding reference symbols indicate corresponding parts, and in which:
- Figures 1a, 1b, 1c, 1d, 1e and 1f schematically depict different embodiments
- Figures 2a, 2b and 2c schematically depict different embodiments
- Figure 3 shows an embodiment comprising a control device
- Figure 4 depicts the oxidation of acetaminophen to iminoquinone and subsequent formation of an adduct of iminoquinone and glutathione
- Figures 5a and 5b depict the extracted ion chromatograms (EIC) produced by a simulated phase II reaction of acetaminophen and glutathione (Fig. 5a) and a control experiment (Fig. 5b)
- Figure 6a depicts the mass spectrum obtained for the HPLC eluate containing the adduct that is formed in the simulated phase II reaction of acetaminophen and glutathione. Figure 6b depicts the mass spectrum obtained for the corresponding eluate sample from a control experiment.

### DETAILED DESCRIPTION OF THE INVENTION

Accordingly, one aspect of the present invention relates to an apparatus for sequentially analyzing a plurality of samples containing electrochemically active substances, said apparatus comprising:
- a sample conduit 10;
- an electrochemical flow cell 20;
- a source of carrier fluid 30;
- a structure elucidation spectrometer 40 selected from a mass spectrometer and a Nuclear Magnetic Resonance (NMR) spectrometer;
- an in-line sample reservoir 50 and
- a conduit 60;
   wherein the apparatus is arranged to operate in:
   a) a first operating modus wherein the sample conduit 10 is connected to the conduit 60 via the electrochemical flow cell 20 and the in-line sample reservoir 50, and the source of carrier fluid 30 is connected to the structure elucidation spectrometer 40 by-passing the in-line sample reservoir 50, and
   b) a second operating modus wherein the sample conduit 10 is connected to the conduit 60 by-passing the in-line sample reservoir 50, and the source of carrier fluid 30 is connected to the structure elucidation spectrometer 40 via the in-line sample reservoir 50.

Examples of such an apparatus will be described in more detail below with reference to the Figures.

The term "electrochemically active substance" as used herein refers to a substance that can be oxidized or reduced by an externally applied voltage.

The term "oxidation" as used herein refers to the loss of electrons / hydrogen or the gain of oxygen / increase in oxidation state by a molecule, atom or ion.

The term "reduction" as used herein refers to the gain of electrons / hydrogen or loss of oxygen / decrease in oxidation state by a molecule, atom or ion.

The terminology "electrochemical oxidation" as used herein refers to an oxidation reaction that occurs in, or is initiated in a solution at the interface of an electron conductor (an electrode) and an ionic conductor (the electrolyte), and which is driven by an external applied voltage.

The terminology "electrochemical reduction" as used herein refers to a reduction reaction that occurs in, or is initiated in a solution at the interface of an electron conductor (an electrode) and an ionic conductor (the electrolyte), and which is driven by an external applied voltage.

The term "electrochemical flow cell" as used herein refers to a cell in which a voltage can be applied to a fluid passing through said cell to oxidize or reduce electrochemically active substances that are contained in the fluid. The term "electrochemical flow cell" encompasses, for instance, electrochemical reactor cells and electrochemical conversion cells. Examples of electrochemical flow cells (or flow-through cells) that may be employed in accordance with the present invention are coulometric as well as amperometric cells, such as, for instance, thin-layer, wall-jet and porous electrode designs.

The term "in-line sample reservoir" as used herein refers to a defined volume comprising an inlet and an outlet. Examples of in-line sample reservoirs include sample loops and sample holding chambers.

The term "sample loop" as used herein refers to an in-line sample reservoir in the form of tubing.

The term "sample conduit" as used herein refers to any kind of inlet arranged to receive a sample.

The present apparatus and method are particularly suited for screening samples containing electrochemically active substances. Naturally, it is inherent to such screening procedures that occasionally samples are included that do not contain detectable levels of electrochemically active substances.

The conduit 60 may be connected to a four-port valve 61, where the four-port valve 61 may further be connected to an aspiration/dispense device 63, a wash bottle 62 comprising a washing liquid and a waste bottle 64 to receive waste liquid.

In a first position, the four-port valve 61 may connect the aspiration/dispensing device 63 to the conduit 60 to aspirate liquid from the conduit 60 into the aspiration/dispensing device 63 or to dispense liquid from the aspiration/dispensing device 63 into the conduit 60.

In a second position the four-port valve 61 may connect the aspiration/dispensing device 63 to the wash bottle 62 to aspirate washing liquid from the wash bottle 62.

In a third position the four-port valve 61 may further connect the aspiration/dispensing device 63 to the waste bottle 64 to dispose liquid into the waste bottle 64.

So, during the first operating modus, the four-port valve 61 may be in the first position during which liquid is aspirated by the aspiration/dispensing device 63 and possibly dispensed, for instance in case the electrochemical flow cell 20 is positioned downstream with respect to the in-line sample reservoir 50 (the downstream direction being defmed as the direction from the sample conduit 10 towards the conduit 60). During the first operation modus, the four-port valve 61 may also be n the third position, in case the aspiration/dispensing device 63 is full and needs to dispense fluid into the waste bottle 64, after which it returns to the first position to continue aspirating.

As will be explained in more detail below, in case washing actions are preformed, the four-port valve 61 may also be in the first and second position during the first operating modus. The second position is used to aspirate washing liquid and the first position is used to dispense the washing liquid.

During the second operating modus, the four-port valve 61 may still be in the first or third position. Again, in case washing actions are performed during the second operating modus (explained in more detail below), the four-port valve 61 may also be in the second position to aspirate wash liquid from the wash bottle 62. After this, the four-port valve 61 may be in the first position to dispense the washing liquid into the conduit 60 towards the sample conduit 10.

In order to derive the full benefits of the present invention it is important that the apparatus can be switched instantaneously from the first operating modus (e.g. load position) to the second operating modus (e.g. inject position) and *vice versa.* Thus, flow interruptions that adversely affect the reliability of the analyses can be avoided. In accordance with a particularly preferred embodiment, the present apparatus employs a multi-port valve to switch between the first and second operating modus.

In accordance with one preferred embodiment the apparatus comprises a multi-port valve comprising a first, a second, a third, a fourth, a fifth and a sixth port 1, 2, 3, 4, 5, 6;
- the sample conduit 10 being in communication with the first port 1;
- the source of carrier fluid 30 being in communication with one of the third and fourth port 3; 4;
- the in-line sample reservoir 50 connecting the second and the fifth port 2, 5;
- the structure elucidation spectrometer 40 being in communication with the other of the third and fourth port 4; 3; and
- the conduit 60 being connected to the sixth port 6;
wherein in the first operating modus, the first port 1 is connected to the second port 2, the third port 3 is connected to the fourth port 4 and the fifth port 5 connected to the sixth port 6; and
wherein in the second operating modus, the first port 1 is connected to the sixth port 6, the second port 2 is connected to the third port 3 and fourth port 4 connected to the fifth port 5.

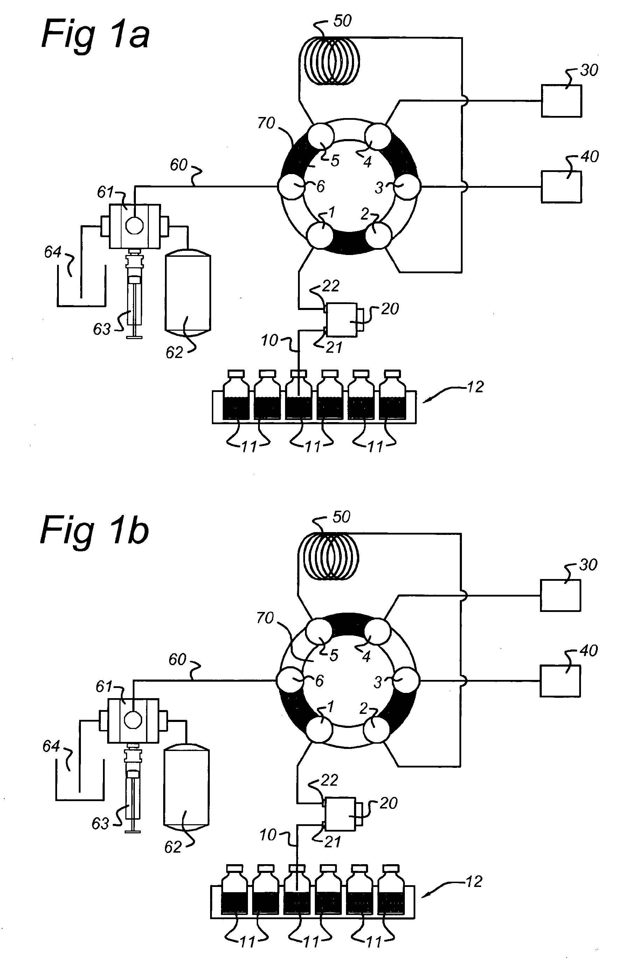

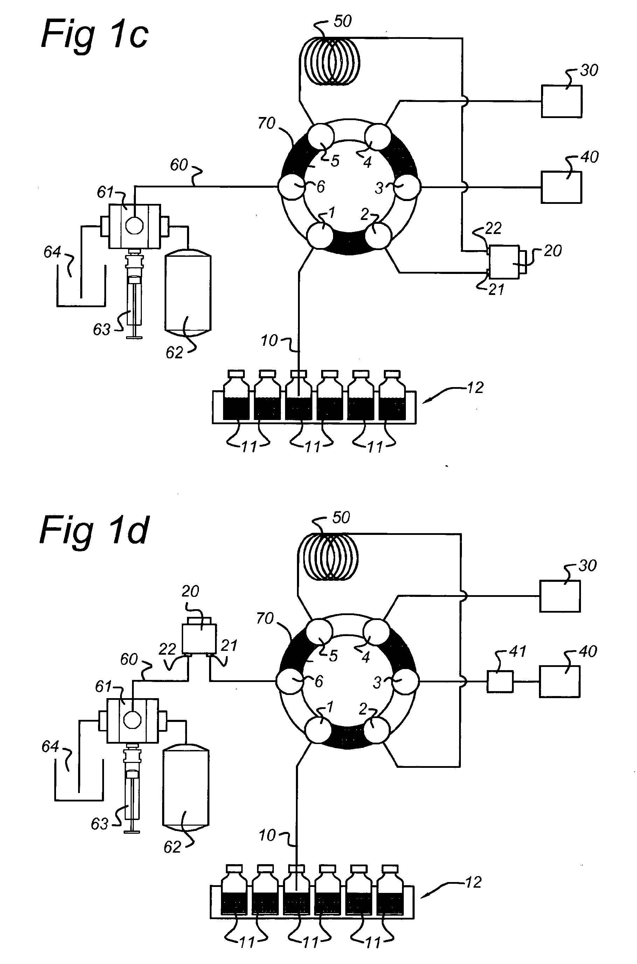

An example of such an apparatus is schematically depicted in Fig.'s 1a and 1b. Fig. 1a shows such an apparatus in the first operating modus, Fig. 1b shows such an apparatus in the second operating modus.

The sample input 10 can be directly connected to the first port 1, but can also be indirectly connected to the first port 1, for instance via the electrochemical flow cell 20 as shown in the examples depicted in Fig.'s 1a and 1b.

The apparatus may suitably contain a source of sample fluid, for instance provided in sample containers 11, in communication with the sample conduit 10.

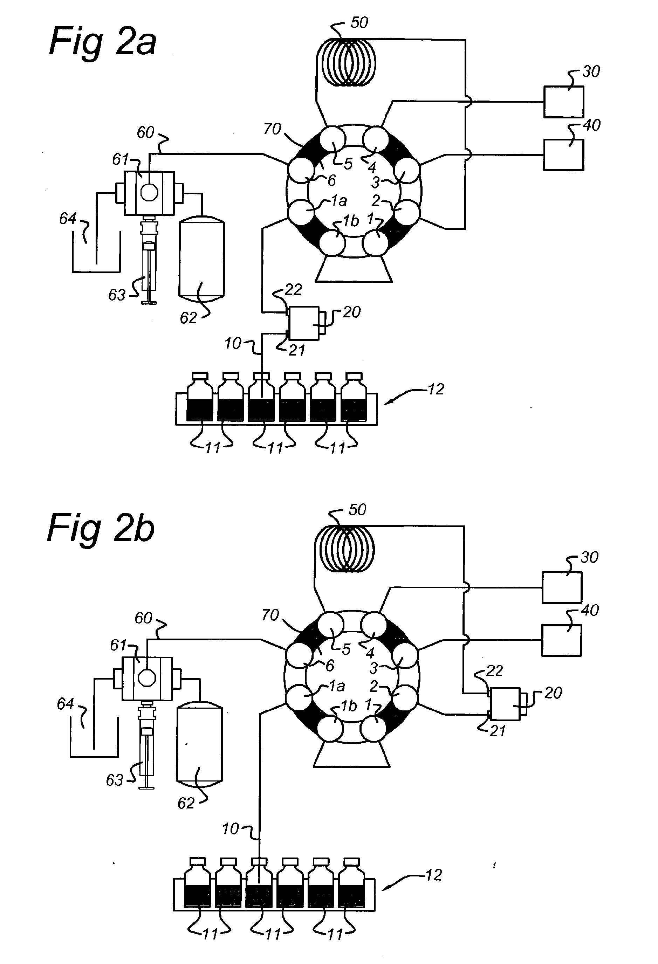

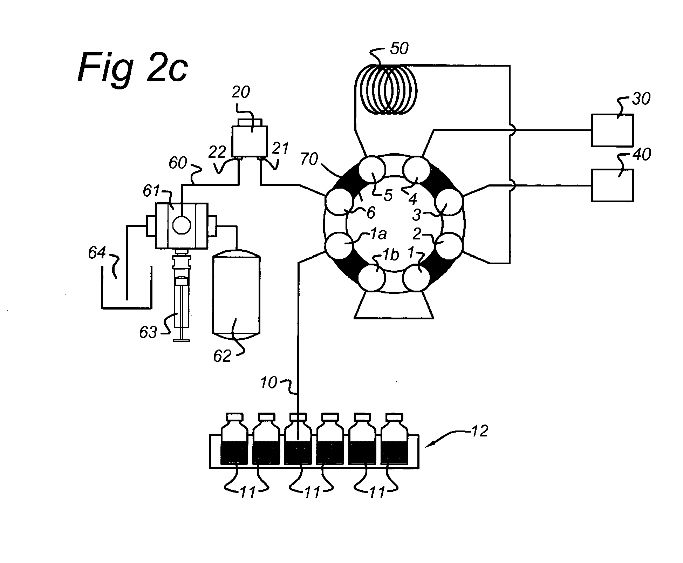

It will be understood that the position of the electrochemical flow cell 20 may be varied and that more than one electrochemical flow cell 20 may be provided. So, there may be provided an apparatus wherein the electrochemical flow cell 20 comprises an inlet 21 and an outlet 22, and wherein the electrochemical flow cell is positioned on at least one of the following positions:
- in between the sample conduit 10 and the first port 1, wherein the inlet 21 of the electrochemical flow cell 20 is connected to the sample conduit 10 and the outlet of the electrochemical flow cell 22 is connected to the first port 1 (see Fig.'s 1a, 1b,),
- in between the sample conduit 10 and the first port 1, wherein the inlet 21 of the electrochemical flow cell 20 is connected to the sample conduit 10 via a first and second further ports 1a, 1b and the outlet of the electrochemical flow cell 22 is connected to the first port 1 (see Fig. 2a),
- in between the second and fifth port 2, 5 in series with the in-line sample reservoir 50 (see Fig.'s 1c and 2b), and
- downstream of the conduit 60 (see Fig. 1d and 2c).

Fig.'s 1c, 1d, 2a, 2b and 2c all show the apparatus in a first operating modus.

According to advantageous embodiments, the electrochemical flow cell 20 is positioned upstream of the in-line sample reservoir 50 to be able to treat the sample before it reaches the in-line sample reservoir 50.

Alternatively, the electrochemical flow cell 20 may be positioned downstream of the in-line sample reservoir, for instance in conduit 60 (see Fig.'s 1d and 2c). The aspiration/dispense device 63 may be used to aspirate liquid through the in-line sample loop 50 into the electrochemical flow cell 20 and subsequently dispose the treated sample back into the in-line sample loop 50 before switching to the second operating modus. In this case, the four-port valve 61 is in the first position.

Typically, the total dead volume of the sample conduit 10 and between the outlet 22 of the electrochemical flow cell 20 and port 1 of the multi-port valve 70 should not exceed 50µl. More preferably, the aforementioned dead volume should not exceed 20µl, most preferably should not exceed 10µl.

In a preferred embodiment the switching valve is grounded to avoid any electrical interference between the electrochemical flow cell and the ESI source (typically, the ESI interface operates at 3-5kV).

Typically, the electrochemical flow cell 20 of the present apparatus has a working volume of 1.0 nl - 10.0 ml. More preferably, the electrochemical flow cell 20 has a working volume of 5.0 nl to 100 µl, even more preferably of 10 nl to 30 µl, and most preferably of 30 nl to 15 µl.

According to a preferred embodiment, the electrochemical flow cell 20 comprises a working electrode, an auxiliary electrode and a reference electrode. Although electrochemical oxidation/reduction of samples can be achieved using a two-electrode system that comprises a working electrode and an auxiliary electrode, the use of a three-electrode system that additionally contains a reference electrode, offers the advantage that changes in working potential due to polarization effects can be avoided.

Examples of working electrodes that may suitably be employed in the present apparatus include a conductive diamond working electrode, a platinum working electrode, a glassy carbon working electrode and a golden working electrode. According to a particularly preferred embodiment, the working electrode is Glassy Carbon or a conductive diamond working electrode, preferably a boron doped diamond electrode or a diamond coated glassy carbon electrode.

The source of carrier fluid 30 in the present apparatus is advantageously capable of providing a continuous flow of carrier fluid to the mass spectrometer 40 in both the first and second operating mode. Typically, the source of carrier fluid 30 comprises a reservoir holding carrier fluid and a pump for transporting the carrier fluid from the reservoir to the mass spectrometer 40.

The functioning of a mass spectrometer or Nuclear Magnetic Resonance spectrometer 40 will be understood by the skilled person.

In accordance with a particularly preferred embodiment, the apparatus further comprises a chemical separation device 41 (shown in Fig. 1d by way of example) connecting the multiport valve 70 with the mass spectrometer 40. Examples of chemical separation devices 41 that may be employed include a liquid chromatograph (including HPLC and UPLC) and an electrophoresis device. Preferably, the chemical separation device 41 is a liquid chromatograph or an electrophoresis device. Even more preferably, the method employs a liquid chromatograph, most preferably an HPLC or an UPLC.

The use of a chemical separation device 41 has the drawback that it takes longer to analyze samples than in case the treated samples are immediately fed to the mass spectrometer 40. However, the introduction of a chemical separation device 41, such as HPLC, offers the very important advantage that the selectivity of analyses can be increased substantially, resulting in improved detection and identification of complex samples.

According to another advantageous embodiment, the present apparatus comprises an autosampler 12 that is capable of holding a plurality of sample containers 11 (e.g. vials, well plates, etc.), said autosampler 12 comprising an aspirating/dispensing device for removing fluid samples from sample containers, and having an outlet that is connected to the sample conduit 10 or comprises the sample conduit 10.

The use of an autosampler 12 enables automatic on-line analysis of a large number of samples. Preferably, the autosampler 12 employed is capable of aspirating at least 10, more preferably at least 20, and most preferably at least 96 test samples in a single run. Here a single run refers to a single operation of the autosampler 12 in which a plurality of samples are processed consecutively in a preprogrammed fashion.

In a special, advantageous embodiment, the autosampler 12 is connected to the electrochemical flow cell 20 via the sample conduit 10 and possibly via the multiport valve 70 described herein before. Thus, the electrochemical cell 20 may be flushed with washing liquid when the apparatus is operated in the second operating modus.

According to another embodiment, the autosampler's aspirating pump (not shown) is capable of conveying a fluid sample to the mass spectrometer 40 via the electrochemical flow cell 20 and the in-line sample reservoir 50.

In a preferred embodiment, the mass spectrometer 40 of the present apparatus comprises an ionization interface selected from Electrospray Ionization (ESI), Matrix Assisted Laser Desorption Ionization (MALDI) and Inductively Coupled Plasma (ICP). Most preferably, the ionization interface employed is ESI. The present apparatus offer the advantage that it can employ all types of ESI (ion spray, electrospray, nano electrospray, etc.) without any modifications/adaptations.

Another aspect of the invention relates to an automated method of sequentially analyzing a plurality of samples containing electrochemically active substances, said method comprising the steps of:
a) providing a first fluid sample into a sample conduit 10;
b) operating an apparatus for sequentially analyzing a plurality of samples in a first operating modus wherein a first flow is generated from the sample conduit 10 to a conduit 60 via an electrochemical flow cell 20 in which a potential is applied to produce a flow of electrochemically treated sample and an in-line sample reservoir 50 to fill the in-line sample reservoir 50 with the electrochemically treated sample, and a second flow is generated from a source of carrier fluid 30 to a structure elucidation spectrometer 40 selected from a mass spectrometer and a NMR spectrometer, said second flow by-passing the in-line sample reservoir 50;
c) switching the apparatus to a second operating modus once the in-line sample reservoir 50 has been filled with treated sample, wherein the first flow is maintained from the sample conduit 10 to the conduit 60, said first flow by-passing the in-line sample reservoir 50, and the second flow is maintained from the source of carrier fluid 30 to the structure elucidation spectrometer 40 via the in-line sample reservoir 50 to transfer at least a part of said treated sample from the in-line sample reservoir 50 to the structure elucidation spectrometer 40;
d) analyzing the at least part of the treated sample in the structure elucidation spectrometer 40;
e) providing another sample into the sample conduit 10 and
f) repeating steps b) to e) for at least 5 more times

Examples of electrochemically active substances that may suitably be contained in the samples include pharmaceutical substances, micronutrients, lipids, proteins, peptides, DNA/RNA and combinations thereof

According to an embodiment, step a) may comprise selecting a first sample container 11 holding a fluid sample and removing at least a part of the fluid sample from said sample container. Step a) may be carried out by a programmed autosampler 12.

It will be understood that the autosampler 12 as shown in the figures is just a specific example and that other devices may be used to provide a sample into the sample conduit 10. For instance, a sample may be provided by a robot arm comprising an injection device arranged to aspirate a sample from a sample container 11, move towards the sample conduit to provide the sample into the sample conduit 10. Of course, many variants may be applied here as will be understood by the skilled person. For example, autosamplers from the manufacturers, Spark Holland, Agilent, CTC, HTA, Thermo, Waters, Shimadzu, Alcott, Metrohm, and Dionex may be used in the invention.

Advantageously, the present method maintains a first flow from the sample conduit 10 to the conduit 60 and a second flow from the source of carrier fluid 30 to the mass spectrometer during the first and second operating modus. This has the advantage that there is no need to interrupt the first and/or the second flow when switching from the first to the second operating modus or *vice versa* and smooth transitions can be obtained. Also, it allows the first and second flows to have a different flow rate.

As will be explained below in more detail the electrochemically treated sample may suitably contain an added reactant. The reactant may be added before or after the fluid sample has been treated in the electrochemical flow cell 20. The present method encompasses a specific embodiment in which a reactant is added to the fluid sample after the electrochemical treatment by the electrochemical flow cell 20 by a procedure comprising: (i) reverting the flow once the in-line sample reservoir has been filled with electrochemically treated sample and collecting the treated sample after it has again passed through the electrochemical flow cell 20; (ii) combining the treated sample with a reactant; and (iii) passing the treated sample containing the added reactant once more through the electrochemical flow cell 20 to fill the in-line sample reservoir 50.

The fluid samples employed in the present method advantageously contain a solvent, preferably a solvent selected from water, organic solvents and combinations thereof. Preferably, solvent is contained in these samples in a sufficient amount to render these samples liquid and should contain a sufficient amount of electrolyte. Typically, the samples contain at least 95 wt.% of solvent, most preferably at least 98 wt.% of solvent. The water content of the samples advantageously exceeds 10 wt.%, most preferably it exceeds 20 wt.%.

The present method is particularly suited for analyzing samples that contain a biological material. Preferably, said biological material is selected from a bodily fluid (e.g. blood or urine), tissue and a material isolated from bodily fluid or tissue (e.g. cells or cell organelles).

The present method is particularly suitable for screening redox reactions that involve oxidative metabolism of drug compounds and xenobiotics. The samples that can be analyzed in the present method may contain electrochemically active compounds within a very wide concentration range. The samples used in the present method suitably contain 1 femtoM to 100 M of these electrochemically active components. Preferably, the samples contain 1 picoM to 0.001 M of these components.

Step a) of the present method is preferably carried out by a programmed autosampler, especially a programmed autosampler as described hereafter.

In a preferred embodiment of the present method the electrochemical flow cell 20 is operated at a flow rate of 1.0 nl/min. to 10 ml/min. The use of an electrochemical flow cell 20 offers the advantage that very small sample volumes can be handled and that `carry-over' effects can be minimized very effectively. Particularly good results can be obtained with the present method using a sample flow rate in the electrochemical flow cell 20 that lies within the range of 10 nl/min. to 3.0 ml/min. Even more preferably, said flow rate lies within the range of 30 nl/min. to 1.0 ml/min. and most preferably the electrochemical flow cell 20 is operated at a flow rate of 100 nl/min. to 300 µl/min.

As explained herein before, the electrochemical flow cell 20 may be used to oxidize or reduce electrochemically active substances. Preferably, the removed fluid sample is passed through the electrochemical flow cell 20 to produce a flow of oxidized sample.

In the present method, typically a voltage in the range of 50 to 5000 mV or - 50 to - 5000 mV is applied to the fluid sample in the electrochemical flow cell 20. Even more preferably, the absolute voltage employed is in the range of 50-3000mV, most preferably in the range of 100-2000 mV.

During its passage through the electrochemical flow cell 20, the fluid sample is typically subjected to the aforementioned voltages for 0.01-1000 seconds (residence time), more particularly 0.1-100 seconds. Most preferably, the samples are subjected to said voltages for 1-10 seconds.

Typically, in step b) of the present method the in-line sample reservoir is filled with 1.0 µl - 5.0 ml, more preferably 5-100 µl, most preferably 10-40 µl of the electrochemically treated sample.

In the present method the filling of the in-line sample reservoir typically takes 0.1 seconds to 100 minutes, more preferably 1 seconds to 30 minutes, and most preferably 10 seconds to 10 minutes.

The present method makes it possible to avoid time-consuming isolation steps that are required to identify for example metabolites from biological matrices obtained in in-vivo experiments. Because the method is highly predictive of the effect of reactants (e.g. drugs, nutrients) on *in vivo* redox processes, said method may advantageously be employed as a screening method to identify agents that potentially have *in vivo* anti-oxidative potency and that may be employed to diminish undesirable oxidation processes in humans or animals. Likewise, the screening method may be employed to evaluate the potential effect of known drugs, nutrients or chemicals (ROS: Reactive Oxygen Species) on *in vivo* redox processes, such as DNA/RNA oxidation processes. The present method can also be used to identify agents that are capable of reacting with redox products. Identification of agents having this capability is important because these agents might induce diverse biological effects due to their mutagenic, genotoxic, or carcinogenic properties.

Thus, in accordance with a particularly preferred embodiment, a reactant to be tested is added to the fluid sample before it is analyzed in the structure elucidation spectrometer 40 and before or after said fluid sample is passed through the electrochemical flow cell 20.

According to an embodiment step b) may further comprise:
b1) reversing the first flow into a reversed first flow to transport the electrochemically treated sample via the sample conduit 10 towards a reactor vial 15 comprising a reactant, and
b2) reversing the reversed first flow to fill the in-line sample reservoir 50 with the sample taken from the reactor vial 15.

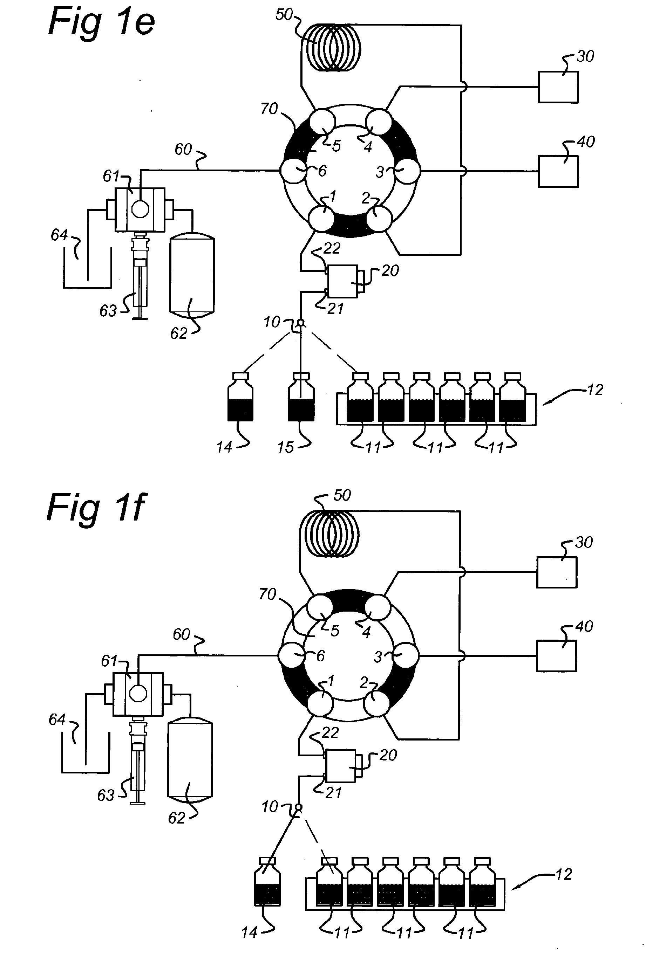

Fig. 1e schematically depicts such an embodiment, which shows the apparatus in the first operating modus, wherein the sample conduit 10 is moved towards the reactor vial 15 for performing b1) and b2). Also shown is a waste container 14 which will be explained in more detail below. The sample conduit 10 may be provided as a robot arm to allow movement.

Of course, the sample conduit 10 may also be fixed while the waste container 14, the reactor vial 15 and the sample containers 11 can move with respect to the sample conduit 10.

The waste container 14 and the reactor vial 15 may be part of or positioned on the auto sampler 12 or may be provided separately.

In this way, the electrochemically treated sample can be transported to a reactor vial in a fast and automated way. Actions b1) and b2) are performed as part of the first operating modus.

Typically, in case of EC/MS, the reactant is added at least 2 seconds before the analysis in the structure elucidation spectrometer 40 in order to allow sufficient time for the agent to interact with redox products. Preferably, the reactant is added at least 5 seconds, more preferably 10-3000 seconds before the analysis in the structure elucidation spectrometer 40.

According to a preferred embodiment, the reactant is added to the fluid sample before the passage through the electrochemical flow cell 20. Most preferably, the reactant is added to the sample before the sample is passed through the electrochemical flow cell 20. Having the reactant present in the sample when redox reactions occur in the electrochemical flow cell 20 offers the advantage that the method may be used to elucidate the effect of the reactant on these redox reactions (e.g. oxidation pathways, oxidation rates). Furthermore, if during passage through the electrochemical cell 20 the reactant is oxidized or reduced, this embodiment enables the study of reactions occurring between the oxidized/reduced reactant and other components contained in the sample.

According to another preferred embodiment, the reactant is added to the fluid sample after the sample has passed through the electrochemical flow cell 20. This embodiment offers the advantage that it is very suitable for elucidating reactions that occur between the reactant and redox products that have formed in the electrochemical flow cell 20. Especially if the reactant itself is likely to be oxidized or reduced in the electrochemical flow cell 20, this embodiment enables the study of reactions occurring between the non-oxidized, non-reduced reactant and redox products that have formed in the electrochemical flow cell 20.

In the present method an autosampler 12 may suitably be used to add reactant to the electrochemically treated sample. According to a particularly preferred embodiment, the same autosampler 12 is used to remove the fluid sample from the sample container and to add a reactant to the treated sample. In accordance with this particular embodiment, step b) of the present automated method comprises the following procedure:
(i) filling the in-line sample reservoir 50 with electrochemically treated sample;
(ii) reverting the flow to remove the treated sample from the in-line sample reservoir 50 and to pass the pre-treated sample through the electrochemical flow cell 20;
(iii) introducing a reactant into the treated sample; and
(iv) passing the treated sample containing the added reactant through the electrochemical flow cell 20 to fill the in-line sample reservoir 50.

In the aforementioned procedure preferably no voltage is applied by the electrochemical flow cell 20 to the treated sample during (iv).

In principle, any type of reactant can suitably be employed in the present method. Preferably, the reactant is selected from a pharmaceutical substance, a micronutrient, lipids, proteins, peptides, DNA/RNA and combinations thereof

According to another particularly preferred embodiment of the invention, the analysis of the treated sample comprises feeding at least a part of the electrochemically treated sample to a chemical separation device 41 is coupled to the mass spectrometer 40 (e.g. HPLC-MS). As explained herein before, examples of chemical separation devices include a liquid chromatograph (e.g. HPLC or UPLC), a solid-phase extraction device and an electrophoresis device.

Advantageously 10 nl to 500 µl of the treated sample is introduced into the chemical separation device 41 for analysis. Even more preferably, the amount of treated sample that is introduced is within the range of 50 nl to 300 µl most preferably within the range of 100 nl to 50 µl.

As explained herein before the use of a chemical separation devices, such as HPLC or UPLC, offers the very important advantage that selectivity of the analyses can be increased substantially even though analysis times are increased by the use of these devices. Thus, in accordance with one advantageous embodiment of the present automated method the treated sample is transferred from the in-line sample reservoir 50 to the mass spectrometer 40 via a liquid chromatograph and the duration of each sample analysis cycle lies within the range of 30 seconds to 90 minutes.

Depending on the nature of the fluid sample, the use of a chemical separation device may be superfluous. If so, it is advantageous not to employ a chemical separation device in order to maximize the S/N ratio and to minimize analysis time. Accordingly, in another advantageous embodiment, the treated sample is not transferred from the in-line sample reservoir 50 to the mass spectrometer 40 via a liquid chromatograph and the duration of each sample analysis cycle lies within the range of 1 second to 15 minutes. This embodiment is also termed as Flow Injection Analysis (FIA)/MS.

The method as described above preferably comprises one or more washing actions. According to an embodiment, step c) of the present method comprises reversing the first flow to generate a wash flow of washing liquid from the conduit 60 to the sample conduit 10. This can be done by switching the four-way valve 61 into the second position to aspirate washing liquid from the wash bottle 62 and subsequently in the first position to dispense the washing liquid into the conduit 60 towards the sample conduit 10 into the waste container 14 (see Fig. 1f). In this washing step the sample conduit 10 may be positioned in or near the waste container 14 This can be done when the second flow is maintained as part of the second operating modus. An example of this is schematically depicted in Fig. 1f, now also showing a waste container 14. The sample conduit 10 may be on a moving arm that can be moved from the sample containers 11 towards the waste container 14 and the reactor vial 15 and back. Of course, although not shown, Fig. 1f may also comprise the reactor vial 15 as described above.

So, in the embodiments wherein the sample is only electrochemically converted and no follow-up reactions are programmed, the washing step may be performed after injection of the electrochemically converted sample present in the in-line sample reservoir 50, i.e. during the second operating modus. The washing may be performed while the sample is still in the chemical separation device 41.

During this washing step a preprogrammed amount of washing liquid (typically 100 - 500 uL) is flushed through the conduit 60, possible through the electrochemical cell 20 and exiting the sample conduit 10.

According to a further embodiment, in case the method comprises steps b1) and b2), action b1) may also comprise a washing step. Action b1) may further comprise generating a wash flow of washing liquid from the conduit 60 to the sample conduit 10 after the electrochemically treated sample is at least partially transported to the reactor vial. This may be done by switching the four-way valve 61 from the first position, into the second position to aspirate washing liquid and subsequently in the first position to dispense the washing liquid into the conduit 60 towards the sample conduit 10. In this washing step the sample conduit 10 may be positioned in or near a waste container 14 as shown by the left dotted line in Fig. 1e.

According to such an embodiment, wherein the sample is first electrochemically converted and the treated sample is subsequently dispensed in a destination container or reactor vial with reactant followed by mixing and injection, there are actually two washing steps:
- The first washing step is performed directly after dispensing a predefined of treated sample into the reactant vial 15 comprising a reactant. In that case the device is still in the first operating status (so the conduit 60 is connected with the sample conduit 10 via the in-line sample reservoir 50) and the remainder of treated sample is flushed out of the flow path (conduit 60, in-line sample reservoir 50, sample conduit 10 and the electrochemical flow cell 20) with washing liquid prior to the switching to the second operating modus. In this washing step the sample conduit 10 is positioned in or near the waste container 14.
- The second washing step is performed in the second operating modus, as described above, thus after removing the sample from the reactant vial 15 and during or after providing the sample to the structure elucidation spectrometer 40 or chemical separation device 41.

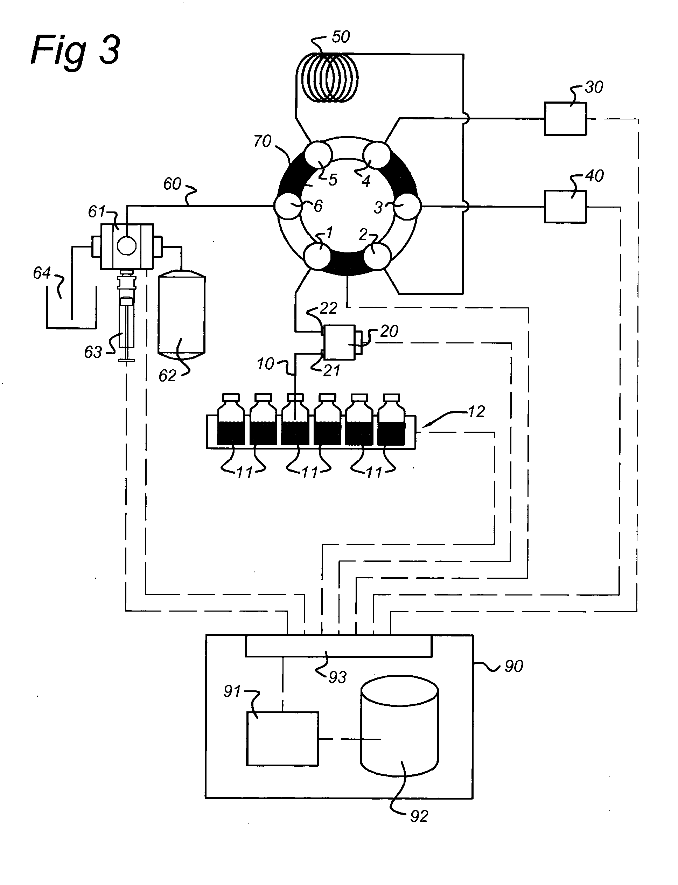

Fig. 3 shows an embodiment of an apparatus for sequentially analyzing a plurality of samples containing electrochemically active substances according to the embodiments provided above, now further comprising a control device 90 arranged as a computer system.

The computer device 90 may be arranged as a personal computer, a server, a laptop, etc.

The computer device 90 comprises a processor unit 91 performing arithmetical operations. The processor unit 91 is connected to a memory unit 92 that is store instructions and data, such as a hard disk, a Read Only Memory (ROM), Electrically Erasable Programmable Read Only Memory (EEPROM), a Random Access Memory (RAM), a CD, a DVD, a USB-stick or combinations thereof.

The computer device 90 may further be connected to user interface devices (not shown) such as a keyboard, a mouse, a display a printer.

The processor unit 91 is connected to an input-output device 93 to enable communication with components of the apparatus for sequentially analyzing a plurality of samples, such as the autosampler 12, the electrochemical flow cell 20 and the potentiostat thereof, the source of carrier fluid 30, the mass spectrometer 40, the multiport valve 70, the four-port valve 61 and aspirating/dispensing device 63.

However, it should be understood that there may be provided more and/or other memory units 92, input devices and read devices known to persons skilled in the art. Moreover, one or more of them may be physically located remote from the processor unit 91, if required. The processor unit 91 is shown as one box, however, it may comprise several processing units functioning in parallel or controlled by one main processor unit that may be located remote from one another, as is known to persons skilled in the art.

It is observed that, although all connections shown in Fig. 3 may be physical connections or wireless connections. They are only intended to show that "connected" units are arranged to communicate with one another.

According to an embodiment, the computer device 90 is arranged to perform any one of the methods provided. In order to do so, the memory unit 92 may comprise instructions that are readable and executable by the processing unit 91. The processing unit 91 is arranged to communicate via the input-output device 93 to send instructions to one or more of the autosampler 12, the electrochemical flow cell 20, the source of carrier fluid 30, the mass spectrometer 40, the in-line sample reservoir 50, the multiport valve 70, the multi valve 6 and piston-cylinder device 64.

A computer program product is provided comprising data and instructions that can be loaded by a computer system, allowing said computer system to perform any of the methods provided above.

A computer readable medium may be provided with such a computer program product.

Optionally, there is provided a computer device arranged to perform any one these methods.

The computer program product may be arranged to allow the computer device to control:
1) an aspirating or pumping (dispensing) device to transport the liquid sample into the electrochemical reactor/conversion cell 20.
2) allows for full control of the flow rate of the aspirating/dispensing device 63 usually in the range of 100 nl/min up to 1.0 ml/min and herewith the control of the transport of the sample through the electrochemical flow cell 20 for optimal conversion, e.g. oxidation, reduction, activation, etc. including stop flow.
3) the switching of the multiport valve 70 to collect, the oxidized sample in the in-line sample reservoir 50 also referred to as storage device on-line connected with switching valve 70
4) the injection of the contents of the in-line sample reservoir 50 towards the mass spectrometer 40 by using either direct Flow injection Analysis-MS (FIA-MS) or chromatographic separation techniques, e.g. HPLC, UPLC, etc., coupled with Mass Spectrometry (LC/MS).
5) Further control of the multi-valve 70 and aspirating/dispensing device 63 to allow the precise addition of reagents, chemicals, etc., of several microliters (typically 1 ul to 1 ml) to the electrochemically modified (activated) sample to allow for example post-reaction adduct formation, e.g., phase II reaction in drug metabolism. This reagent addition can be also conducted pre-reaction (study of antioxidants, etc).
6) control of said multi-valve 70 and aspirating/dispensing device 63 to allow the rigorous flushing of all parts that comes in contact with the sample, to prevent sample carry over and to condition the device for the next sample analysis.
7) That provides the start signal to trigger the MS acquisition and chromatographic separation. The descriptions above are intended to be illustrative, not limiting. Thus, it will be apparent to one skilled in the art that modifications may be made to the invention as described without departing from the scope of the claims set out below.

The invention is further illustrated by means of the following non-limiting Example.

### EXAMPLE

An EC/LC/MS configuration according to the present invention comprising a electrochemical flow cell integrated into the autosampler flow path of an EC/LC system was used to demonstrate the potential of the present invention.

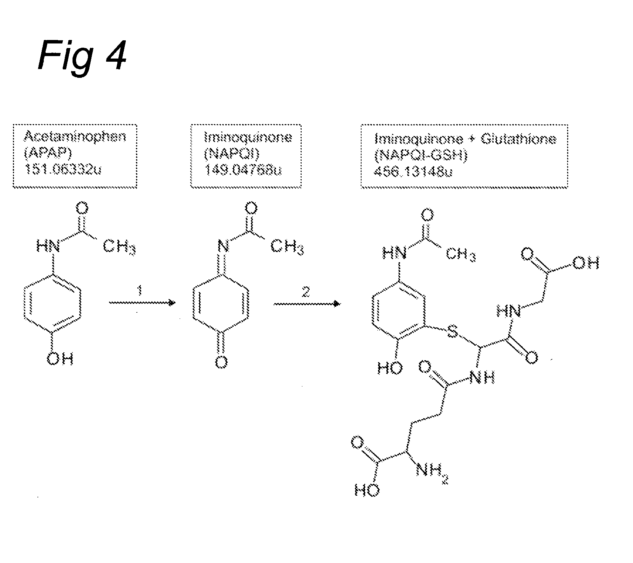

Acetaminophen (APAP) was chosen as a model compound for evaluation, using a ROXY™ EC/LC System (Antec Leyden BV, the Netherlands). APAP is a non-narcotic, analgesic and antipyretic drug, widely used as a pain relief medicine. Acetaminophen is metabolized in the liver by enzyme cytochrome P 450 to a highly reactive metabolite - N-acetyl-p-benzoquinoneimine (NAPQI) - which can cause acute hepatic necrosis if not followed by conjugation with glutathione (GSH). The oxidation of APAP to NAPQI and subsequent formation of the NAPQI-GSH adduct is depicted in Figure 4.

The ROXY™ EC/LC System for automated screening includes a dedicated potentiostat equipped with a ReactorCell™, the autosampler (AS110), two HPLC pumps (LC110) and all necessary LC connections for immediate installation and use up-front the MS. The pumps were configured to work in a gradient mode and final mobile phase composition was made by mixing phase A and B in 250µL binary tee mixer. The ROXY™ EC/LC System is controlled by Clarity™ software (DataApex). The ReactorCell™ with Glassy Carbon working electrode and HyREF™ reference electrode was used for the generation of acetaminophen metabolites. The configuration of the ROXY™ EC/LC system is summarized in Table 1.

**Table 1**

| ROXY™ EC/LC configuration | |
|---|---|
| 1 | AS 110 autosampler, cool, micro, 6-PV |
| 2 | Reactor cell with Glassy Carbon WE, and HyREF |
| 3 | LC 110 HPLC pump, 2x |
| 4 | OR 110 organiser rack, dual channel |
| 5 | ROXY™ potentiostat DCC |
| 6 | Clarity ™ data acquisition software, incl. LC, AS modules |

The sample delivery and injection were automated by means of user defined programs (UDP) of the autosampler. Additionally, the reaction procedure for conjugation glutathione with reactive metabolite of the investigated drug (phase II metabolism) was optimized and automated. The potential applied to the Working Electrode was controlled by potentiostat and programmed with Clarity software. The value of the optimal potential needed for acetaminophen oxidation was based on a mass voltammogram. Operating conditions of the HPLC are summarized in Table 2.

**Table 2**

| Conditions | |
|---|---|
| Flow rate | 300 µl/min |
| Column | BetaSil Phenyl, 250x3mm; 3µm |
| Injection | 10 µl |
| Mobile phase | A. 20 mM ammonium acetate pH 6.9 |
| | B. 50% methanol |
| Potential | Off or 800 mV |
| Standard phase I | 10 µm acetaminophen in A |
| Standard phase II | 1. 10µM acetaminophen in A |
| | 2. 50µM GSH* in A |
| | (25µL of 1 mixed with 50µL of 2) |

| | |
|---|---|
| *GSH should be freshly prepared to avoid spontaneous oxidation | |

The special flow path was designed for automated screening of multiple samples with ROXY EC/LC system. The ReactorCell was connected directly in the autosampler injection valve. The volume of the buffer tubing, speed of autosampler syringe was optimized for presented configuration of the injection valve. The 25µL syringe was used to handle the lowest speed of the syringe (for UDP the lowest speed is 3µL/min). Furthermore, the trigger cable was designed to control of all possible functions of autosampler and potentiostat (Table 3).

**Table 3**

| | |
|---|---|
| AS110 | ROXY™ potentiostat |
| Starting Clarity™ | Starting MS |
| Cell OFF | Cell OFF |
| Cell ON | Cell ON |

The gradient used is described in Table 4. Total measurement time was 17 min. and additional time for column equilibration was provided during sample aspiration.

**Table 4**

| Time [min.] | A [%] | B [%] |
|---|---|---|
| Initial | 90.0 | 10.0 |
| 2.00 | 90.0 | 10.0 |
| 3.00 | 50.0 | 50.0 |
| 15.00 | 50.0 | 50.0 |
| 16.00 | 90.0 | 10.0 |

A MicrOTOF-Q (Bruker Daltonik, Germany) with Apollo II ion funnel electrospray source was used to record mass spectra. MS data were analyzed by Compass™ software. The relevant mass spectrometer parameters are listed in the Table 5. The method was optimized on a 10µM paracetamol solution. Mass spectrometer calibration was performed using sodium formate clusters at the beginning of the measurements.

**Table 5**

| **Parameter** | **Value** |
|---|---|
| Mass range | 50 - 1000 m/z |
| Ion polarity | Positive |
| Capillary voltage | -4500 V |
| Nebulizer | 1.6 Bar |
| Dry gas | 8 L/min |
| Temperature | 200 °C |
| Funnel 1 RF | 200 Vpp |
| Funnel 2 RF | 200 Vpp |
| ISCID energy | 0 eV |
| Hexapole | 100 Vpp |
| Ion energy | 5 eV |

For investigating of phase II metabolism, two experiments were performed:
1) Control
   - In this experiment no potential was applied to ReactorCell™. This experiment helps to check the system performance and can be used to confirm that metabolites are generated in the ReactorCell as a result of the potential applied therein.
2) Reactive metabolite(s) conjugation reaction.
   - In this experiment a potential of 800mV was applied to the ReactorCell (with Glassy Carbon working electrode) to generate metabolites. The acetaminophen was oxidized in the ReactorCell™ and then 25µL of oxidized acetaminophen solution was mixed in the destination vial containing 50µL of GSH solution. Next, the sample loop was filled with the reaction product and injected into the column.

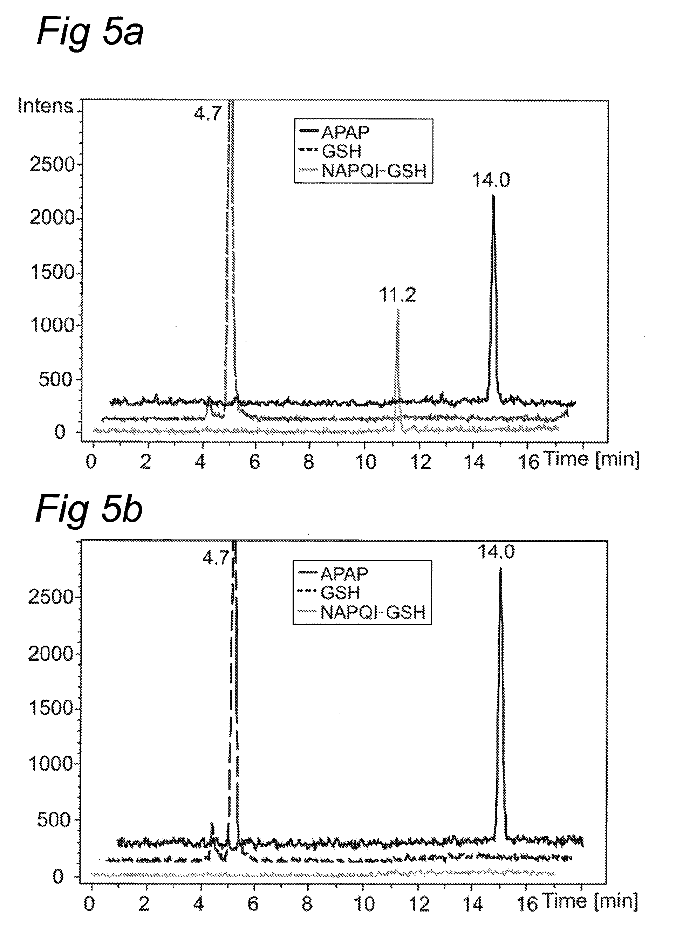

Figures 5a and 5b show the results obtained for the conjugation experiment (Figure 5a) and the control experiment (Figure 5b). A conjugation product, eluting at 11.2 minutes and corresponding to m/z of 457 Th, is only formed in the conjugation experiment.

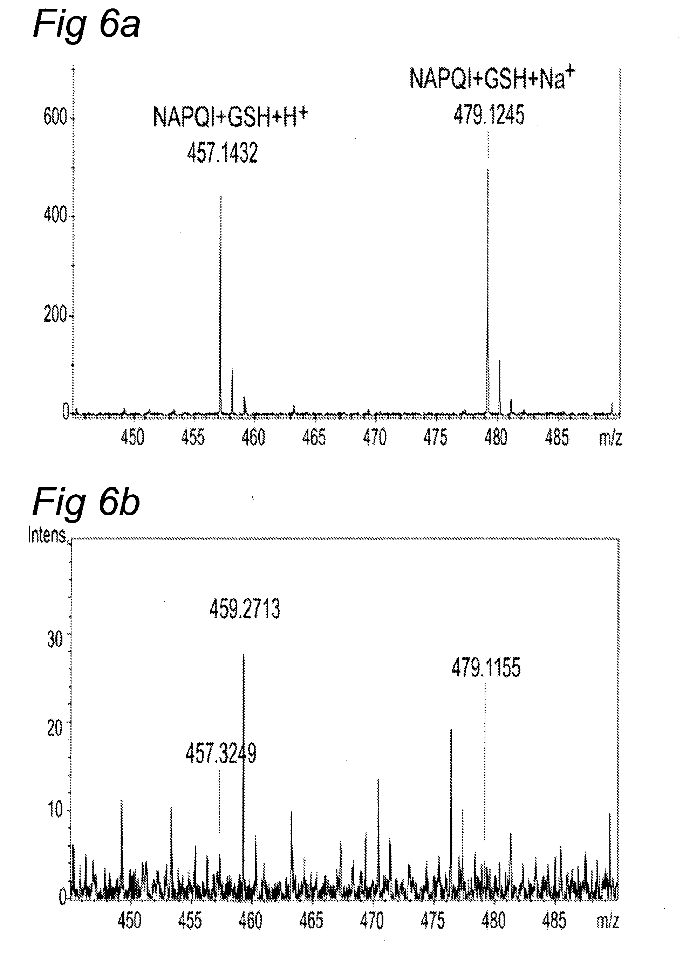

To confirm the formation of a conjugation product of acetaminophen reactive metabolite (NAPQI) and GSH, mass spectra were plotted for the compound eluting at 11.2 minutes for both the conjugation experiment (Fig. 6a) and the control experiment (Fig. 6b). The protonated ion of NAPQI-GSH conjugate (m/z = 457.1432 Th) as well as its sodium adduct (m/z = 479.1245 Th) were identified in the sample produced in the conjugation experiment (Fig.6a). In the corresponding sample obtained from the control experiment these adducts could not be detected (Fig. 6b).

## Claims

1. An apparatus for sequentially analyzing a plurality of samples containing electrochemically active substances, said apparatus comprising:
• a sample conduit (10);
• an electrochemical flow cell (20);
• a source of carrier fluid (30);
• a structure elucidation spectrometer (40) selected from a mass spectrometer and a Nuclear Magnetic Resonance (NMR) spectrometer;
• an in-line sample reservoir (50) and
• a conduit (60),
wherein the apparatus is arranged to operate in:
a) a first operating modus wherein the sample conduit (10) is connected to the conduit (60) via the electrochemical flow cell (20) and the in-line sample reservoir (50), and the source of carrier fluid (30) is connected to the structure elucidation spectrometer (40) by-passing the in-line sample reservoir (50), and
b) a second operating modus wherein the sample conduit (10) is connected to the conduit (60) by-passing the in-line sample reservoir (50), and the source of carrier fluid (30) is connected to the structure elucidation spectrometer (40) via the in-line sample reservoir (50).

2. Apparatus according to claim 1, wherein the apparatus comprises a multi-port valve comprising a first, a second, a third, a fourth, a fifth and a sixth port (1, 2, 3, 4, 5, 6);
• the sample conduit (10) being in communication with the first port (1);
• the source of carrier fluid (30) being in communication with one of the third and fourth port (3; 4);
• the in-line sample reservoir (50) connecting the second and the fifth port (2, 5);
• the structure elucidation spectrometer (40) being in communication with the other of the third and fourth port (4; 3); and
• the conduit (60) being connected to the sixth port (6);
wherein in the first operating modus, the first port (1) is connected to the second port (2), the third port (3) is connected to the fourth port (4) and the fifth port (5) connected to the sixth port (6); and
wherein in the second operating modus, the first port (1) is connected to the sixth port (6), the second port (2) is connected to the third port (3) and fourth port (4) connected to the fifth port (5).

3. Apparatus according to claim 2, wherein the electrochemical flow cell (20) comprises an inlet (21) and an outlet (22), and wherein the electrochemical flow cell is positioned on at least one of the following positions:
- in between the sample conduit (10) and the first port (1), wherein the inlet (21) of the electrochemical flow cell (20) is connected to the sample conduit (10) and the outlet of the electrochemical flow cell (22) is connected to the first port (1),
- in between the sample conduit (10) and the first port (1), wherein the inlet (21) of the electrochemical flow cell (20) is connected to the sample conduit (10) via a first and second further ports (1a, 1b) and the outlet of the electrochemical flow cell (22) is connected to the first port (1),
- in between the second and fifth port (2, 5) in series with the in-line sample reservoir (50), and
- downstream of the conduit (60).

4. Apparatus according to any one of the preceding claims, wherein the apparatus further comprises a chemical separation device (41) connecting the multiport valve (70) with the structure elucidation spectrometer (40).

5. Apparatus according to any one of the preceding claims, wherein the apparatus further comprises an autosampler (12) that is capable of holding a plurality of sample containers (11), that comprises an aspirating device (63) for removing fluid samples from sample containers (11) and that has an outlet that is connected to the sample conduit (10).

6. Apparatus according to any one of the preceding claims, wherein the apparatus further comprises a computer device (90) for operating the apparatus to switch from the first operating mode to the second operating mode and *vice versa.*

7. An automated method of sequentially analyzing a plurality of samples containing electrochemically active substances, said method comprising the steps of:
a) providing a first fluid sample into a sample conduit (10);
b) operating an apparatus for sequentially analyzing a plurality of samples in a first operating modus wherein a first flow is generated from the sample conduit (10) to a conduit (60) via an electrochemical flow cell (20) in which a potential is applied to produce a flow of electrochemically treated sample and an in-line sample reservoir (50) to fill the in-line sample reservoir (50) with the electrochemically treated sample, and a second flow is generated from a source of carrier fluid (30) to a structure elucidation spectrometer (40) selected from a mass spectrometer and a NMR spectrometer, said second flow by-passing the in-line sample reservoir (50);
c) switching the apparatus to a second operating modus once the in-line sample reservoir (50) has been filled with treated sample, wherein the first flow is maintained from the sample conduit (10) to the conduit (60), said first flow by-passing the in-line sample reservoir (50), and the second flow is maintained from the source of carrier fluid (30) to the structure elucidation spectrometer (40) via the in-line sample reservoir (50) to transfer at least a part of said treated sample from the in-line sample reservoir (50) to the structure elucidation spectrometer (40);
d) analyzing the at least part of the treated sample in the structure elucidation spectrometer (40);
e) providing another sample into the sample conduit (10) and
f) repeating steps b) to e) for at least 5 more times.

8. Automated method according to claim 7, wherein b) further comprises:
b1) reversing the first flow into a reversed first flow to transport the electrochemically treated sample via the sample conduit (10) towards a reactor vial comprising a reactant, and
b2) reversing the reversed first flow to fill the in-line sample reservoir (50) with the sample.

9. Automated method according to claim 8, wherein the reactant is selected from a pharmaceutical substance, a micronutrient, lipids, proteins, peptides, DNA/RNA and combinations thereof.

10. Automated method according to any one of claims 7-9, wherein step a) comprises selecting a first sample container holding a fluid sample and removing at least a part of the fluid sample from said sample container, step a) being carried out by a programmed autosampler.

11. Automated method according to any one of the claims 7-10, wherein action c) further comprises reversing the first flow to generate a wash flow of washing liquid from the conduit (60) to the sample conduit (10).

12. Automated method according to claim 8, wherein action b1) further comprises generating a wash flow of washing liquid from the conduit (60) to the sample conduit (10) after the electrochemically treated sample is at least partially transported to the reactor vial.

## Patentansprüche

1. Eine Vorrichtung zum sequenziellen Analysieren einer Mehrzahl von Proben, welche elektrochemisch aktive Substanzen enthalten, wobei die besagte Vorrichtung aufweist:
• eine Probenleitung (10),
• eine elektrochemische Flusszelle (20),
• eine Trägerfluidquelle (30),
• ein Strukturaufklärungsspektrometer (40), welches von einem Massenspektrometer und einem Kernspinresonanzspektrometer (NMR) ausgewählt ist,
• ein in-Reihe-Probenreservoir (50) und
• eine Leitung (60),
wobei die Vorrichtung eingerichtet ist, um betrieben zu werden:
a) in einem ersten Betriebsmodus, wobei die Probenleitung (10) mittels der elektrochemischen Flusszelle (20) und dem in-Reihe-Probenreservoir (50) mit der Leitung (60) verbunden ist und die Trägerfluidquelle (30) unter Umgehung des in-Reihe-Probenreservoirs (50) mit dem Strukturaufklärungsspektrometer (40) verbunden ist, und
b) in einem zweiten Betriebsmodus, wobei die Probenleitung (10) unter Umgehung des in-Reihe-Probenreservoirs (50) mit der Leitung (60) verbunden ist und die Trägerfluidquelle (30) mittels des in-Reihe-Probenreservoirs (50) mit dem Strukturaufklärungsspektrometer (40) verbunden ist.

2. Vorrichtung gemäß Anspruch 1, wobei die Vorrichtung ein Mehrwegeventil aufweist, welches eine erste, eine zweite, eine dritte, eine vierte, eine fünfte und eine sechste Ventilöffnung (1, 2, 3, 4, 5, 6) aufweist,
• die Probenleitung (10) mit der ersten Ventilöffnung (1) in Kommunikation ist,
• die Trägerfluidquelle (30) mit einer von der dritten und von der vierten Ventilöffnung (3, 4) in Kommunikation ist,
• das in-Reihe-Probenreservoir (50) die zweite und die fünfte Ventilöffnung (2, 5) verbindet,
• das Strukturaufklärungsspektrometer (40) mit der anderen von der dritten und von der vierten (3, 4) Ventilöffnung in Kommunikation ist, und
• die Leitung (60) mit der sechsten Ventilöffnung (6) verbunden ist,
wobei im ersten Betriebsmodus die erste Ventilöffnung (1) mit der zweiten Ventilöffnung (2) verbunden ist, die dritte Ventilöffnung (3) mit der vierten Ventilöffnung (4) verbunden ist und die fünfte Ventilöffnung (5) mit der sechsten Ventilöffnung (6) verbunden ist, und
wobei im zweiten Betriebsmodus die erste Ventilöffnung (1) mit der sechsten Ventilöffnung (6) verbunden ist, die zweite Ventilöffnung (2) mit der dritten Ventilöffnung (3) verbunden ist und die vierte Ventilöffnung (4) mit der fünften Ventilöffnung (5) verbunden ist.

3. Vorrichtung gemäß Anspruch 2, wobei die elektrochemische Flusszelle (20) einen Einlass (21) und einen Auslass (22) aufweist, und wobei die elektrochemische Flusszelle an wenigstens einer der folgenden Positionen positioniert ist:
- zwischen der Probenleitung (10) und der ersten Ventilöffnung (1), wobei der Einlass (21) der elektrochemischen Flusszelle (20) mit der Probenleitung (10) verbunden ist und der Auslass der elektrochemischen Flusszelle (22) mit der ersten Ventilöffnung (1) verbunden ist,
- zwischen der Probenleitung (10) und der ersten Ventilöffnung (1), wobei der Einlass (21) der elektrochemischen Flusszelle (20) mittels einer weiteren ersten und zweiten Ventilöffnung (1a, 1b) mit der Probenleitung (10) verbunden ist und der Auslass der elektrochemischen Flusszelle (22) mit der ersten Ventilöffnung (1) verbunden ist,
- zwischen der zweiten und der fünften Ventilöffnung (2, 5), in Reihe mit dem in-Reihe-Probenreservoir (50), und
- stromabwärts von der Leitung (60).

4. Vorrichtung gemäß irgendeinem der vorhergehenden Ansprüche, wobei die Vorrichtung weiter eine chemische Separationsvorrichtung (41) aufweist, welche das Mehrwegeventil (70) mit dem Strukturaufklärungsspektrometer (40) verbindet.

5. Vorrichtung gemäß irgendeinem der vorhergehenden Ansprüche, wobei die Vorrichtung weiter einen Probengeber (12) aufweist, der in der Lage ist, eine Mehrzahl von Probenbehältern (11) zu halten, der eine Ansaugvorrichtung (63) zum Entfernen von Fluidproben aus Probenbehältern (11) aufweist und der einen Auslass hat, der mit der Probenleitung (10) verbunden ist.

6. Vorrichtung gemäß irgendeinem der vorhergehenden Ansprüche, wobei die Vorrichtung weiter eine Computervorrichtung (90) zum Betreiben der Vorrichtung aufweist, um vom ersten Betriebsmodus in den zweiten Betriebsmodus zu schalten und umgekehrt.

7. Ein automatisiertes Verfahren zum sequenziellen Analysieren einer Mehrzahl von Proben, welche elektrochemisch aktive Substanzen enthalten, wobei das besagte Verfahren folgende Schritte aufweist:
a) Einbringen einer ersten Fluidprobe in eine Probenleitung (10) hinein,
b) Betreiben einer Vorrichtung zum sequenziellen Analysieren einer Mehrzahl von Proben in einem ersten Betriebsmodus, wobei eine erste Strömung von der Probenleitung (10) mittels einer elektrochemischen Flusszelle (20), in welcher ein Potential angelegt wird, um eine Strömung einer elektrochemisch behandelten Probe zu produzieren, und eines in-Reihe-Probenreservoirs (50), um das in-Reihe-Probenreservoir (50) mit der elektrochemisch behandelten Probe zu füllen, zu einer Leitung (60) erzeugt wird, und eine zweite Strömung von einer Trägerfluidquelle (30) zu einem von einem Massenspektrometer und einem NMR-Spektrometer ausgewählten Strukturaufklärungsspektrometer (40) erzeugt wird, wobei die besagte zweite Strömung das in-Reihe-Probenreservoir (50) umgeht,
c) Umschalten der Vorrichtung in einen zweiten Betriebsmodus, sobald das in-Reihe-Probenreservoir (50) mit der behandelten Probe gefüllt wurde, wobei die erste Strömung von der Probenleitung (10) zur Leitung (60) beibehalten wird, wobei die besagte erste Strömung das in-Reihe-Probenreservoir (50) umgeht, und die zweite Strömung von der Trägerfluidquelle (30) mittels des in-Reihe-Probenreservoirs (50) zum Strukturaufklärungsspektrometer (40) beibehalten wird, um zumindest einen Teil der besagten behandelten Probe vom in-Reihe-Reservoir (50) zum Strukturaufklärungsspektrometer (40) zu transferieren,
d) Analysieren des zumindest einen Teils der behandelten Probe im Strukturaufklärungsspektrometer (40),
e) Einbringen einer weiteren Probe in die Probenleitung (10) hinein, und
f) Wiederholen der Schritte b) bis e) für zumindest 5 weitere Male.

8. Automatisiertes Verfahren gemäß Anspruch 7, wobei b) weiter aufweist:
b1) Umkehren der ersten Strömung in eine umgekehrte erste Strömung, um die elektrochemisch behandelte Probe mittels der Probenleitung (10) zu einer Reaktionsampulle, welche ein Reaktionsmittel beinhaltet, hin zu transportieren, und
b2) Umkehren der umgekehrten ersten Strömung, um das in-Reihe-Probenreservoir (50) mit der Probe zu füllen.

9. Automatisiertes Verfahren gemäß Anspruch 8, wobei das Reaktionsmittel von einer pharmazeutischen Substanz, einem Mikronährstoff, Lipiden, Proteinen, Peptiden, DNA/RNA und Kombinationen davon ausgewählt ist.

10. Automatisiertes Verfahren gemäß irgendeinem der Ansprüche 7 bis 9, wobei der Schritt a) aufweist ein Auswählen eines ersten Probenbehälters, welcher eine Fluidprobe enthält, und ein Entfernen zumindest eines Teils der Fluidprobe vom besagten Behälter, wobei der Schritt a) mittels eines programmierten Probengebers ausgeführt wird.

11. Automatisiertes Verfahren gemäß irgendeinem der Ansprüche 7 bis 10, wobei die Aktion c) weiter aufweist ein Umkehren der ersten Strömung, um eine Waschströmung von Waschflüssigkeit aus der ersten Leitung (60) zur Probenleitung (10) zu erzeugen.

12. Automatisiertes Verfahren gemäß Anspruch 8, wobei die Aktion b1) weiter aufweist ein Generieren einer Waschströmung aus Waschflüssigkeit von der Leitung (60) zur Probenleitung (10) nachdem die elektrochemisch behandelte Probe zumindest teilweise zur Reaktorampulle transportiert wurde.

## Revendications

1. Appareil destiné à analyser de manière séquentielle une pluralité d'échantillons qui contiennent des substances électrochimiquement actives, ledit appareil comprenant :
- un conduit d'échantillon (10) ;
- une cellule électrochimique à flux continu (20) ;
- une source de fluide transporteur (30) ;
- un spectromètre d'élucidation de structures (40) choisi parmi un spectromètre de masse et un spectromètre de résonance magnétique nucléaire (RMN) ;
- un réservoir d'échantillon en ligne (50) ; et
- un conduit (60),
dans lequel l'appareil est agencé de façon à fonctionner dans :
a) un premier mode de fonctionnement dans lequel le conduit d'échantillon (10) est relié au conduit (60) par l'intermédiaire de la cellule électrochimique à flux continu (20) et du réservoir d'échantillon en ligne (50), et la source de fluide transporteur (30) est reliée au spectromètre d'élucidation de structures (40) en contournant le réservoir d'échantillon en ligne (50) ; et
b) un second mode de fonctionnement dans lequel le conduit d'échantillon (10) est relié au conduit (60) en contournant le réservoir d'échantillon en ligne (50), et la source de fluide transporteur (30) est reliée au spectromètre d'élucidation de structures (40) par l'intermédiaire du réservoir d'échantillon en ligne (50).

2. Appareil selon la revendication 1, dans lequel l'appareil comprend une vanne multivoies qui comprend des première, deuxième, troisième, quatrième, cinquième et sixième voies (1, 2, 3, 4, 5, 6) ;
- le conduit d'échantillon (10) étant en communication avec la première voie (1) ;
- la source de fluide transporteur (30) étant en communication avec l'une de la troisième et de la quatrième voie (3, 4) ;
- le réservoir d'échantillon en ligne (50) reliant les deuxième et cinquième voies (2, 5) ;
- le spectromètre d'élucidation de structures (40) étant en communication avec l'autre de la troisième et de la quatrième voie (4, 3) ; et
- le conduit (60) étant relié à la sixième voie (6) ;
dans lequel, dans le premier mode de fonctionnement, la première voie (1) est reliée à la deuxième voie (2), la troisième voie (3) est reliée à la quatrième voie (4) et la cinquième voie (5) est reliée à la sixième voie (6) ; et
dans lequel, dans le second mode de fonctionnement, la première voie (1) est reliée à la sixième voie (6), la deuxième voie (2) est reliée à la troisième voie (3) et la quatrième voie (4) est reliée à la cinquième voie (5).

3. Appareil selon la revendication 2, dans lequel la cellule électrochimique à flux continu (20) comprend une entrée (21) et une sortie (22), et dans lequel la cellule électrochimique à flux continu est positionnée sur l'au moins une des positions suivantes :
- entre le conduit d'échantillon (10) et la première voie (1), dans lequel l'entrée (21) de la cellule électrochimique à flux continu (20) est reliée au conduit d'échantillon (10) et la sortie de la cellule électrochimique à flux continu (22) est reliée à la première voie (1) ;
- entre le conduit d'échantillon (10) et le premier orifice (1), dans lequel l'entrée (21) de la cellule électrochimique à flux continu (20) est reliée au conduit d'échantillon (10) par l'intermédiaire d'une première et d'une deuxième autres voies (1a, 1b), et la sortie de la cellule électrochimique à flux continu (22) est reliée à la première voie (1) ;
- entre les deuxième et cinquième voies (2, 5) en série avec le réservoir d'échantillon en ligne (50) ; et
- en aval du conduit (60).

4. Appareil selon l'une quelconque des revendications précédentes, dans lequel l'appareil comprend en outre un dispositif de séparation chimique (41) qui relie la vanne multivoies (70) au spectromètre d'élucidation de structures (40).

5. Appareil selon l'une quelconque des revendications précédentes, dans lequel l'appareil comprend en outre un dispositif d'échantillonnage automatique (12) qui est capable de contenir une pluralité de contenants d'échantillons (11), qui comprend un dispositif d'aspiration (63) destiné à prélever des échantillons liquides à partir des contenants d'échantillons (11) et qui présente une sortie qui est reliée au conduit d'échantillon (10).

6. Appareil selon l'une quelconque des revendications précédentes, dans lequel l'appareil comprend en outre un dispositif informatique (90) destiné à commander l'appareil de façon à basculer du premier mode de fonctionnement vers le second mode de fonctionnement et *vice versa.*

7. Procédé automatisé destiné à analyser de manière séquentielle une pluralité d'échantillons qui contiennent des substances électrochimiquement actives, ledit procédé comprenant les étapes de :
a) l'introduction d'un premier échantillon liquide dans un conduit d'échantillon (10) ;
b) la commande d'un appareil destiné à analyser de manière séquentielle une pluralité d'échantillons dans un premier mode de fonctionnement dans lequel un premier flux est créé à partir du conduit d'échantillon (10) vers un conduit (60) par l'intermédiaire d'une cellule électrochimique à flux continu (20) dans laquelle un potentiel est appliqué de façon à produire un flux d'un échantillon traité électrochimiquement, et d'un réservoir d'échantillon en ligne (50) de façon à remplir le réservoir d'échantillon en ligne (50) avec l'échantillon traité électrochimiquement, et un second flux est créé à partir d'une source de fluide transporteur (30) vers un spectromètre d'élucidation de structures (40) choisi parmi un spectromètre de masse et un spectromètre RMN, ledit deuxième flux contournant le réservoir d'échantillon en ligne (50) ;
c) la bascule de l'appareil vers un second mode de fonctionnement une fois que le réservoir d'échantillon en ligne (50) ait été rempli avec l'échantillon traité, dans lequel le premier flux est maintenu à partir du conduit d'échantillon (10) vers le conduit (60), ledit premier flux contournant le réservoir d'échantillon en ligne (50), et le deuxième flux est maintenu à partir de la source de fluide transporteur (30) vers le spectromètre d'élucidation de structures (40) par l'intermédiaire du réservoir d'échantillon en ligne (50) de façon à transférer au moins une partie dudit échantillon traité à partir du réservoir d'échantillon en ligne (50) vers le spectromètre d'élucidation de structures (40) ;
d) l'analyse de l'au moins une partie de l'échantillon traité dans le spectromètre d'élucidation de structures (40) ;
e) l'introduction d'un autre échantillon dans le conduit d'échantillon (10) ; et
f) la répétition des étapes b) à e) au moins 5 autres fois.

8. Procédé automatisé selon la revendication 7, dans lequel l'étape b) comprend en outre :
b1) l'inversement du premier flux en un premier flux inversé de façon à transporter l'échantillon traité électrochimiquement par l'intermédiaire du conduit d'échantillon (10) vers une fiole de réacteur qui comprend un réactif ; et
b2) l'inversement du premier flux inversé de façon à remplir le réservoir d'échantillon en ligne (50) avec l'échantillon.

9. Procédé automatisé selon la revendication 8, dans lequel le réactif est choisi parmi une substance pharmaceutique, un micronutriment, des lipides, des protéines, des peptides, un ADN/un ARN et des combinaisons de ceux-ci.

10. Procédé automatisé selon l'une quelconque des revendications 7 à 9, dans lequel l'étape a) comprend le choix d'un premier contenant d'échantillon qui contient un échantillon liquide et le prélèvement d'au moins une partie de l'échantillon liquide à partir dudit contenant d'échantillon, l'étape a) étant exécutée au moyen d'un dispositif d'échantillonnage automatique programmé.

11. Procédé automatisé selon l'une quelconque des revendications 7 à 10, dans lequel l'étape c) comprend en outre l'inversement du premier flux de façon à créer un flux de lavage de liquide de lavage à partir du conduit (60) vers le conduit d'échantillon (10).

12. Procédé automatisé selon la revendication 8, dans lequel l'étape b1) comprend en outre la création d'un flux de lavage de liquide de lavage à partir du conduit (60) vers le conduit d'échantillon (10) une fois que l'échantillon traité électrochimiquement ait été transporté en partie au moins vers la fiole de réacteur.
